# EUROPEAN PATENT SPECIFICATION

(11) **EP 0 366 282 B1**
(45) Date of publication and mention of the grant of the patent: **30.11.1994**
(21) Application number: 89310097.4
(22) Date of filing: 03.10.1989
(51) Int. Cl.: H01L 23/24, H01L 23/31

(54) **Cavity packages**
Hohlgehäuse
Boitiers à cavité

(30) Priority: 27.10.1988 GB 8825201
(43) Date of publication of application: 02.05.1990
(73) Proprietor: DOW CORNING S.A., B-6198 Seneffe (BE)
(72) Inventor: Paquet, René Louis Mathieu André, B-1428 Lillois (BE)
(74) Representative: Bullows, Michael

(56) References cited:
- EP-A- 0 006 509
- EP-A- 0 186 099
- EP-A- 0 216 352
- PATENT ABSTRACTS OF JAPAN vol. 11, no. 320 (E-550)(2767) 17 October 1987 & JP-A-62 111453
- 1988 Proceedings of the 38th Electronic Components Conference,May 9-11,1988,LosAngeles, CA,US pages 452 - 456; H.ISHIDA ET AL.: "Characterization of a Silicone Gel as a Coating Use for Corrosion Protection"
- IEEE TRANSACTIONS ON COMPONENTS,HYBRIDS,AND MANUFACTURING TECHNOLOGY vol. 7,no. 3, September 1984, NEW YORK US pages 249 - 256; K.OTSUKA ET AL.: "A New Silicone Gel Sealing Mechanism for High Reliability Encapsulation"

## Description

This invention is concerned with cavity packages.

The expression "cavity package" where used herein embraces articles in the form of a package within which an operative element, for example a semiconductor, integrated circuit or other electronic device, is contained. Power packages are well known in the art and formerly were made by moulding a thermosetting material onto the operative element. More recently, it has been proposed to employ packages which comprise a package body premoulded from a thermoplastic material and having a bore or cavity extending through the thickness of the body and in which the operative element is contained. The thermoplastic material may be, for example, polyphenylsulphone or polybutylterephthalate and the package may comprise a heat sink and a metal lead frame for electrical and/or thermal connection of the operative element to other devices. A silicon die or semiconductor chip or other operative element may be bonded into the cavity which may then be partially filled with a deposit of a silicone composition which cures to provide a layer of a soft and self-sealing silicone gel. A lid, for example of polyphenylsulphone may be secured in the cavity over the gel for example by an adhesive bonding agent.

The operative element in a package as just above referred to is protected by the gel against effects of atmospheric humidity and contaminants present in the atmosphere. The packages are thus commercially acceptable in many respects. However, the silicone gel-forming compositions used have wetting and flow characteristics such that the gel layer develops a concave meniscus and thus the amount of gel covering the operative element at the centre of the cavity is limited, resulting in a tendency to fill the cavity to an extent such that the edge portions of the layer interfere with correct positioning of the lid. Attempts have been made to overcome this difficulty using various techniques, for example adjustment of the viscosity or cure speed of the deposit of silicone composition, variation of the temperature at which the deposit is applied or cured, variation of the application pressure of the deposit and preheating of the package body. Whilst some control of the flow and seepage of the deposit may be achieved by use of such techniques nevertheless it remains a problem to maximise the filling of the available space in the cavity by the gel whilst limiting interference of the gel with the location of the lid.

It is an object of the present invention to provide an improved method of making a cavity package.

We have now found that an improved disposition of the gel in the package body of a cavity package of the type referred to above may be achieved by application of a coating of a surface-active composition comprising a fluorine compound on sidewall portions of the cavity, at those areas of the cavity which are adjacent a surface of the package body to which the lid is to be attached, prior to application of the deposit of silicone gel-forming composition to cover the operative element.

The present invention provides in one of its aspects a method of making a cavity package which comprises procuring a package body having a cavity within which an operative element is located and having a securing surface to which a lid may be secured, and applying onto the operative element in the cavity a deposit of a silicone gel-forming composition to cover the operative element with a layer of desired thickness of silicone gel characterised in that prior to application of the deposit of silicone gel-forming composition to cover the operative element a coating of a surface-active composition comprising a fluorine compound is formed on sidewall surfaces of the cavity at those areas of the cavity which are adjacent the securing surface of the package body which surface active composition restricts the flow of the silicone gel up the sidewall surfaces of the cavity, the gel thereby being induced to adopt a convex meniscus.

In a method according to the invention the package body may be formed by injection moulding a thermoplastic material for example polyphenylsulphone to any desired shape and thickness. The shape and thickness may be dictated by the intended location of the cavity package in apparatus of which it is intended to form a part in juxtaposition to other parts. Conveniently it is in the form of a cuboid and may have a metal lead frame comprising several metal connectors extending from one or more of its side surfaces. As mentioned the package body incorporates a cavity in which, in the completed package, the operative element is positioned below the layer of gel. Sidewall surfaces of the package body defining the cavity thus extend heightwise with respect to the gel covered operative element. Conveniently the cavity may be provided in a bore extending through the thickness of the package body. The securing surface of the block may be an outer surface of the block adjacent the mouth of the bore, or may be provided by a lip formed in the bore at a depth such that an outer surface of the lid may be coplanar with the outer surface of the block. The operative element may be a silicon die or semiconductor chip or other element and may be secured e.g. by adhesive to a heat sink secured to the block. In a preferred form of package body hereinafter described, the package body consists of a rectangular block of substantially uniform thickness moulded from polyphenylsulphone resin; the cavity is part of a stepped bore which extends heightwise through the thickness of the block and opens into an enlarged upper portion of the bore in which the securing surface is provided; the operative element is a silicon semiconductor chip and is mounted on a heat sink secured in an enlarged lower portion of the bore; and metal lead frames for electrical and/or thermal connection of the operative element to other devices extend from two side surfaces of the block and are connected to the operative element.

In a method according to the invention the coating of surface-active composition is formed on sidewall portions of the cavity at those areas of the cavity which are adjacent the securing surface of the package body. A lower edge of the coating is located so that flow of the gel up the walls of the cavity is restricted, whereby to induce the gel to adopt a somewhat convex meniscus. The non-concave nature of the upper surface of the cured gel layer is important to production of an improved disposition of the gel over the operative element at the centre of the cavity without encroachment of edge portions of the layer of gel onto the securing surfaces. It is an important feature of the present invention that the lower edge of the coating is precisely defined. It is also desirable that the upper edge of the coating is clearly defined in order that it does not interfere with securing of a lid to the package body. If necessary, gel which has encroached onto the securing surface may subsequently be removed using solvent. Various techniques are known to those skilled in the art for precise application of very thin layers of compositions to provide thin coatings in selected regions of an article. Suitable methods include printing and stamping.

In a method according to the invention it is unnecessary and undesirable to apply a coating of more than a few microns thickness and therefore the viscosity of the surface active composition is suitably adjusted with solvents and/or extenders in accordance with the application technique to be used for application of the coating to the cavity walls and in accordance with the fact that a uniform coating is required on defined areas of a surface which may be vertical at the time of application. The surface-active composition may thus comprise the fluorine compound alone or in conjunction with solvents, for example volatile alcohols e.g. isopropanol or fluorocarbons e.g. chlorofluorohydrocarbons and/or other materials. The fluorine compound may comprise a fluorinated aliphatic material of the type known to have surfactant properties. The fluorine compound is preferably a non-ionic material and may be for example a fluorinated alkyl ester. Preferred fluorine compounds are fluoroaliphatic copolymers, the most preferred being those which polymerise readily at room or elevated temperature. A preferred fluorine compound is poly(1H,1H-pentadecylfluorooctylmethacrylate).

In a method according to the invention the silicone gel-forming composition may be any of those commercially available materials having the required degree of purity for semiconductor applications. Silicone gel-forming compositions have been known for many years. They can be cured to provide non-elastomeric materials characterised by low physical strength as demonstrated by poor tear strength, elongation and tensile strength and low hardness. They are neither solid nor liquid and usually flow under pressure. These materials have been described in several patent specifications, for example G.B. -A- 0 849 885, and typically comprise an intimate mixture of (i) an organopolysiloxane having a viscosity of from 100 to 10,000 mm²/s at 25°C which is a copolymer of units of the general formulae RViSiO, R₂SiO and CH₃R₂SiO_{0.5} where each R represents a methyl or phenyl group and Vi represents a vinyl group; (ii) a liquid hydrogensiloxane of the general formula HRCH₃SiO(R₂SiO)ₙSiCH₃RH where each R represents a methyl or a phenyl group and n has an average value such that the hydrogensiloxane has a viscosity of not more than about 10,000 mm²/s and (iii) a platinum catalyst, the R groups of (i) and (ii) being at least predominantly methyl groups.

In a method according to the invention a metered amount of the silicone gel-forming composition is applied as a deposit in the cavity on top of the operative element. The amount metered is sufficient to cover the operative element with a layer of desired thickness and to flow into the lower confines of the cavity. The deposit is cured, for example at 150°C for 30 minutes. As the silicone composition settles and edge portions of the layer creep upwards in contact with the sidewalls of the cavity, their upward movement is checked by the coating of surfactant on the wall surface, but the centre of the deposit may continue to rise so that the layer has a somewhat convex meniscus thus ensuring that an adequate depth of the layer exists above the operative element without the silicone contaminating the securing surface of the package.

A lid may be secured to the block in any suitable fashion, for example by ultrasonic techniques or by use of suitable adhesives for example those based on silicone, epoxy resins or polyurethanes.

There now follows a description to be read with the accompanying drawings of one example method according to the invention.

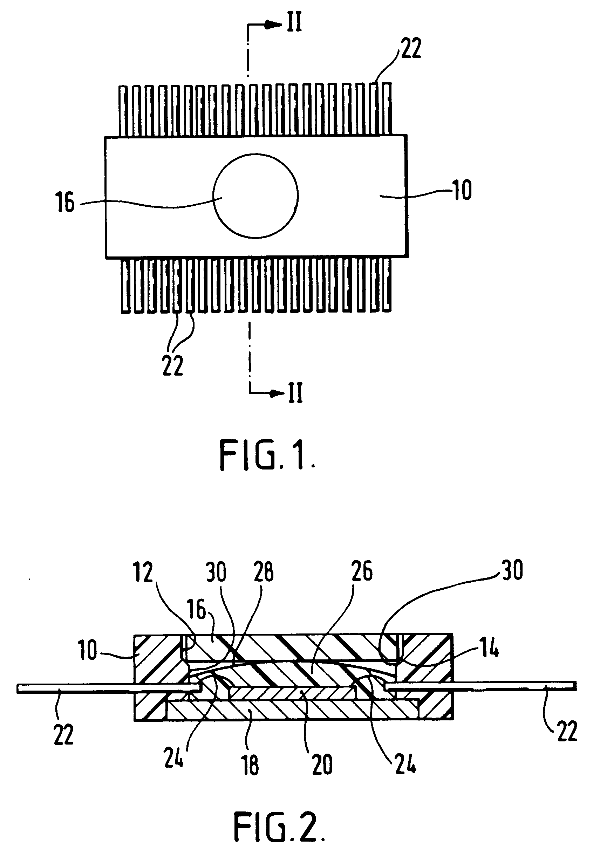

In the drawings, Figure 1 is a plan view of a cavity package prepared by use of the example method, and Figure 2 is a sectional view taken substantially on the line II - II of Figure 1.

The cavity package shown in the drawings comprises a rectangular block (10) of substantially uniform thickness moulded from polyphenylsulphone. A stepped bore (12) extends heightwise (as viewed in Figure 2) through the thickness of the block and is wider at its open ends than at its mid region. An upper end of the bore has a lip (14) which provides a securing surface of the block adjacent to the upper surface of the block (as viewed in Figure 2). A lid (16) is secured to the lip with its upper surface flush with the upper surface of the block (10). The lower portion of the bore is shaped to receive a heat sink (18) which is bonded in place with adhesive. A silicon semiconductor chip (20) is adhesively bonded to the heat sink. Metal lead frames (22) for electrical and/or thermal connection of the operative element to other devices are connected to the semiconductor chip by leads (24) and extend from opposite side surfaces of the block. A layer of silicone gel (26) is located on and around the semiconductor chip (20) and the leads (24), in the cavity defined by the sidewalls of the bore (12) below the lip (14), and by the heat sink (18).

In the example method a coating of a surface-active composition designated Fluorad® Surface Modifier FC-723, which is understood to be a 0.2% solution of poly(1H,1H-pentadecylfluorooctylmethacrylate) in fluorocarbon solvents, was applied as a narrow circular band (30) around the inner surfaces of the bore by stamping it onto sidewall portions (30) of the cavity just below (as viewed in Figure 2) the lip (14) i.e. at that end of the cavity which is adjacent the securing surface of the package body. The lower edge of the coating was located at a level to be above the semiconductor chip but below the lip (14) as viewed in Figure 2. The coating was allowed to dry at room temperature. The heat sink (18) with the semiconductor chip (20) bonded thereto was adhesively bonded to the block in the position shown in Figure 2. A deposit of a silicone gel-forming composition was metered into the cavity on top of the semiconductor chip (20), the heat sink (18) and the leads (24). The silicone gel-forming composition was formed by mixing components comprising 99 parts by weight of a dimethylvinylsiloxy end-blocked polydimethylsiloxane having a viscosity of about 450 mm²/s, 0.4 part by weight of a low molecular weight branched polysiloxane containing Me₂SiO and MeViSiO units (where Me represents a methyl group and Vi represents a vinyl group), 0.8 part by weight of a polysiloxane consisting of Me₂SiO, MeHSiO and Me₃SiO_{½} units and having a viscosity of about 5 mm²/s, and 0.2 part of a platinum containing catalyst for the SiH, SiVi addition reaction. The assembly was placed in an oven heated to 150°C for 30 minutes to cure the silicone gel. It was found that the layer of cured gel had a convex meniscus (28) and that its edge portions had not encroached onto the lip (14). The lid was adhesively bonded in place.

## Claims

1. A method of making a cavity package which comprises procuring a package body (10) having a cavity within which an operative element (20) is located and having a securing surface (14) to which a lid (16) may be secured, and applying onto the operative element in the cavity a deposit of a silicone gel-forming composition to cover the operative element with a layer of desired thickness of silicone gel (26) characterised in that prior to application of the deposit of silicone gel-forming composition to cover the operative element a coating of a surface-active composition comprising a fluorine compound is formed on sidewall-surfaces of the cavity at those areas (30) of the cavity which are adjacent the securing surface (14) of the package body which surface active composition restricts the flow of the silicone gel up the sidewall surfaces of the cavity, the gel thereby being induced to adopt a convex meniscus.

2. A method according to Claim 1 wherein the fluorine compound is a fluorinated aliphatic material.

3. A method according to Claim 1 wherein the fluorine compound is a polymerisable fluoroaliphatic polymer.

4. A method according to Claim 1 wherein the surface active composition comprises poly(1H,1H,-pentadecylfluorooctylmethacrylate).

5. A method according to Claim 1 wherein the surface-active composition is applied to the surfaces of the cavity by a stamping process.

6. A method according to any one of the preceding claims wherein the silicone gel-forming composition comprises an intimate mixture of (i) an organopolysiloxane having a viscosity from 100 to 10,000 mm²/s at 25°C which is a copolymer of units of the general formulae RViSiO, R₂SiO and CH₃R₂SiO_{0.5} where each R represents a methyl or phenyl group and Vi represents a vinyl group; (ii) a liquid hydrogensiloxane of the general formula HRCH₃SiO(R₂SiO)ₙSiCH₃RH where each R represents a methyl or a phenyl group and n has an average value such that the hydrogensiloxane has a viscosity of not more than about 10,000 mm²/s and (iii) a platinum catalyst, the R groups of (i) and (ii) being at least predominantly methyl groups.

7. A method according to Claim 1 wherein the operative element (20) comprises a silicon die or semiconductor chip secured to a heat sink (18) secured to the package body (10).

8. A method according to Claim 1 wherein a lid (16) is secured to the securing surface (14) of the package body (10).

## Patentansprüche

1. Verfahren zur Herstellung eines Hohlgehäuses umfassend, daß man einen Gehäusekörper (10) mit einem Hohlraum, in dem ein operatives Element (20) angeordnet ist, und mit einer Befestigungsoberfläche (14), an der ein Deckel (16) befestigt werden kann, bereitstellt und auf das operative Element in dem Hohlraum eine Auflage aus einer silicongelbildenden Zusammensetzung aufträgt, um das operative Element mit einer Schicht mit einer gewünschten Dicke aus Silicongel (26) zu bedecken, **dadurch gekennzeichnet, daß** vor dem Auftragen der Auflage aus der silicongelbildenden Zusammensetzung, um das operative Element zu bedecken, eine Beschichtung aus einer oberflächenaktiven Zusammensetzung, die eine Fluorverbindung umfaßt, auf den Seitenflächen des Hohlraums in solchen Bereichen (30) des Hohlraums gebildet wird, die der Befestigungsoberfläche (14) des Gehäusekörpers benachbart sind, wobei die oberflächenaktive Zusammensetzung das Fließen des Silicongels an den Seitenwänden des Hohlraums hinauf beschränkt, wodurch das Gel einen konvexen Meniskus annehmen soll.

2. Verfahren nach Anspruch 1, worin die Fluorverbindung ein fluoriertes aliphatisches Material ist.

3. Verfahren nach Anspruch 1, worin die Fluorverbindung ein polymerisierbares fluoraliphatisches Polymer ist.

4. Verfahren nach Anspruch 1, worin die oberflächenaktive Zusammensetzung Poly(1H,1H-pentadecylfluoroctylmethacrylat) umfaßt.

5. Verfahren nach Anspruch 1, worin die oberflächenaktive Zusammensetzung auf die Oberflächen des Hohlraums mit einem Prägeverfahren aufgetragen wird.

6. Verfahren nach einem der vorhergehenden Ansprüche, worin die silicongelbildende Zusammensetzung eine innige Mischung umfaßt aus (i) einem Organopolysiloxan mit einer Viskosität von 100 bis 10.000 mm²/s bei 25°C, das ein Copolymer ist aus Einheiten der allgemeinen Formeln RViSiO, R₂SiO und CH₃R₂SiO_{0,5}, worin jeder Rest R eine Methyl- oder Phenylgruppe ist und Vi eine Vinylgruppe bedeutet; (ii) einem flüssigen Hydrogensiloxan der allgemeinen Formel HRCH₃SiO(R₂SiO)ₙSiCH₃RH, worin jeder Rest R eine Methyl- oder Phenylgruppe bedeutet und n einen solchen Durchschnittswert hat, daß das Hydrogensiloxan eine Viskosität von nicht mehr als etwa 10.000 mm²/s hat und (iii) einem Platinkatalysator, wobei die Gruppen R von (i) und (ii) zumindest hauptsächlich Methylgruppen sind.

7. Verfahren nach Anspruch 1, worin das operative Element (20) einen Siliciumchip oder Halbleiterchip umfaßt, der an einem Wärmeableiter (18) befestigt ist, der an dem Gehäusekörper (10) befestigt ist.

8. Verfahren nach Anspruch 1, worin ein Deckel (16) an der Befestigungsoberfläche (14) des Gehäusekörpers (10) befestigt ist.

## Revendications

1. Un procédé de fabrication d'un boîtier à cavité qui consiste à obtenir un corps (10) de boîtier ayant une cavité dans laquelle est disposé un élément actif (20) et ayant une surface d'ancrage (14) à laquelle un capot (16) peut être fixé, et à appliquer sur l'élément actif présent dans la cavité un dépôt d'une composition formatrice de gel de silicone pour recouvrir l'élément actif par une couche d'épaisseur désirée de gel de silicone (26), caractérisé en ce que, avant l'application du dépôt de composition formatrice de gel de silicone pour recouvrir l'élément actif, un revêtement d'une composition tensio-active comprenant un composé fluoré est formé sur les surfaces latérales de la cavité au niveau des zones (30) de la cavité qui sont adjacentes à la surface d'ancrage (14) du corps du boîtier, laquelle composition tensio-active limite l'écoulement du gel de silicone vers le haut des surfaces latérales de la cavité, le gel étant ainsi amené à adopter la forme d'un ménisque convexe.

2. Un procédé selon la revendication 1, dans lequel le composé fluoré est une substance aliphatique fluorée.

3. Un procédé selon la revendication 1, dans lequel le composé fluoré est un polymère aliphatique fluoré polymérisable.

4. Un procédé selon la revendication 1, dans lequel la composition tensio-active comprend du poly(1H,1H-pentadécylfluorooctylméthacrylate).

5. Un procédé selon la revendication 1, dans lequel la composition tensio-active est appliquée aux surfaces de la cavité par une opération de timbrage.

6. Un procédé selon l'une quelconque des revendications précédentes, dans lequel la composition formatrice de gel de silicone comprend un mélange intime de (i) un organopolysiloxane ayant une viscosité de 100 à 10 000 mm²/s à 25°C qui est un copolymère de motifs des formules générales RViSiO, R₂SiO et CH₃R₂SiO_{0,5} où chaque R représente un groupe méthyle ou phényle et Vi représente un groupe vinyle ; (ii) un hydrogénosiloxane liquide de la formule générale HRCH₃SiO(R₂SiO)ₙSiCH₃RH où chaque R représente un groupe méthyle ou phényle et la valeur moyenne de n est telle que l'hydrogénosiloxane ait une viscosité d'au plus environ 10 000 mm²/s ; et (iii) un catalyseur au platine, les groupes R de (i) et (ii) étant au moins en majeure partie des groupes méthyle.

7. Un procédé selon la revendication 1, dans lequel l'élément actif (20) comprend une pastille de silicium ou une puce de semi-conducteur fixée à un dissipateur de chaleur (18) fixé au corps (10) de boîtier.

8. Un procédé selon la revendication 1, dans lequel un capot (16) est fixé à la surface d'ancrage (14) du corps (10) de boîtier.
